# EUROPÄISCHE PATENTSCHRIFT

(11) **EP 1 507 131 B1**
(45) Veröffentlichungstag und Bekanntmachung des Hinweises auf die Patenterteilung: **13.04.2011**
(21) Anmeldenummer: 04027488.8
(22) Anmeldetag: 27.04.2001
(51) Int. Cl.: G01D 5/26, G01B 11/00, H01L 31/02

(54) **Abtasteinheit für eine optische Positionsmesseinrichtung**
Scanning unit for an optical position measuring device
Unité de balayage pour un dispositif optique de mesure de la position

(30) Priorität: 28.04.2000 DE 10022619
(43) Veröffentlichungstag der Anmeldung: 16.02.2005
(62) Teilanmeldung aus: 01936033.8
(73) Patentinhaber: Dr. Johannes Heidenhain GmbH, 83292 Traunreut (DE)
(72) Erfinder: Mayer, Elmar, 83365 Nussdorf (DE); Holzapfel, Wolfgang, 83119 Obing (DE); Löschke, Klaus, 12527 Berlin (DE)

(56) Entgegenhaltungen:
- WO-A1-99/08074
- US-A- 4 652 693
- PATENT ABSTRACTS OF JAPAN Bd. 009, Nr. 329 (P-416), 24. Dezember 1985 (1985-12-24) -& JP 60 154112 A (SANKUSU KK), 13. August 1985 (1985-08-13)

## Beschreibung

Die Erfindung bezieht sich auf eine Abtasteinheit für eine optische Positionsmesseinrichtung gemäß dem Oberbegriff des Anspruchs 1.

Aus der WO 99/08074 ist eine Abtasteinheit für eine optische Positionsmeßeinrichtung bekannt, die neben periodischen Inkrementalsignalen auch mindestens ein Referenzimpulssignal bei einer definierten Referenzposition eines Maßstabes und einer relativ dazu beweglichen Abtasteinheit liefert. Auf den Maßstab ist mindestens ein Referenzmarkierungsfeld in einer Inkrementalteilungsspur integriert angeordnet und die Abtasteinheit umfaßt eine Detektoranordnung, die in Meßrichtung mindestens drei benachbart angeordnete, aktive Detektorbereiche aufweist. Zwei der drei Detektorbereiche bilden Referenzimpulssignal-Detektorbereiche und dienen zur Erzeugung eines Referenzimpulssignales, wobei die Relativanordnung der Referenzimpulssignal-Detektorbereiche in Meßrichtung in Abhängigkeit von der Strukturierung des Referenzmarkierungsfeldes auf den Maßstab gewählt ist. Ein zwischen den Referenzimpulssignal-Detektorbereichen angeordneter Detektorbereich dient zur Erzeugung mindestens eines Inkrementalsignales.

Wie insbesondere der Figur 3a dieser Druckschrift mit einer Anordnung aktiver Detektorbereiche sowohl für Referenzimpulssignal-Detektorbereiche als auch für Inkrementalsignal-Detektorbereiche zu entnehmen ist, erfolgt die Kontaktierung der verschiedenen aktiven Detektorbereiche an den Stirnseiten der Detektorbereiche und infolge der zahlrei chen parallelen Leitungsführungen benötigt die Anordnung seitlich der Detektorbereiche viel Platz auf der Platine bzw. dem Halbleitersubstrat des Fotodetektors, auf dem die aktiven Detektorbereiche und die Kontaktierungs-Leiterbahnen anzuordnen sind. Dieser seitlich der aktiven Detektorbereiche benötigte Platz für die Leiterbahnen kann daher nicht für die aktiven Detektorbereiche auf dem Halbleitersubstrat zur Aufnahme der Detektorbereiche und Leiterbahnen verwendet werden.

Zur Erzeugung der Inkremental- und Referenzimpulssignale ist es jedoch von besonderer Bedeutung, die strahlungsempfindlichen Detektorbereiche des Fotodetektors möglichst großflächig zu machen, um auf der Empfangsseite der Abtasteinheit möglichst viel im Durchlicht- oder Auflichtverfahren empfangenes Licht einzukoppeln. Dem steht allerdings die Miniaturisierung der optischen Positionsmeßeinrichtungentgegen, bei der die Abtasteinheit ein möglichst kleines Volumen beanspruchen soll, was dazu führt, daß für die Detektorbereiche auf dem Substrat eine nur geringe Fläche zur Verfügung steht. Auf dieser Fläche müssen bei einer Relativ-und Absolutmessung sowohl die Inkrementalsignal-Detektorbereiche als auch die Referenzimpuls-Detektorbereiche so angeordnet werden, daß auch unter ungünstigen Bedingungen wie starken Verschmutzungen eine einwandfreie Erfassung und Abgabe von Inkremental- und Referenzimpulssignalen gewährleistet ist.

Aus der JP 60-154112 A ist ein flächiges optoelektrisches Detektorelement bekannt, das vier kreissegementförmige lichtempfindliche Detektorbereiche aufweist. Diese Bereiche werden jeweils über separate Elektroden kontaktiert.

Die US 4,652,693 offenbart ein Array aus einzelnen Streifen mit optoelektrischen Detektorelementen. Die elektrische Kontaktierung der Detektorelemente erfolgt über seitlich angeordnete Bus-Elektroden. Aufgabe der vorliegenden Erfindung ist es daher, die für die Detektorbereiche auf dem Substrat eines Fotodetektors einer Abtasteinheit verfügbare Fläche optimal zu nutzen.

Diese Aufgabe wird erfindungsgemäß durch die Merkmale des Anspruchs 1 gelöst.

Die erfindungsgemäße Lösung ermöglicht die optimale Nutzung der für die Detektorbereiche auf dem Substrat eines Fotode tektors einer Abtasteinheit verfügbaren Fläche zur Erzeugung von Inkrementalsignalen und ggf. Referenzimpulssignalen, indem die gesamte Substrat- oder Platinenfläche, insbesondere die quer zur Meßrichtung verlaufende Breite des Substrats vollständig für die Detektorbereiche genutzt werden kann, da die zu den einzelnen Detektorbereichen führenden Leiterbahnen über die Oberfläche der Detektorbereiche geführt und mit den jeweiligen Detektorbereichen verbunden sind. Die optimale Ausnutzung der teuren (Silizium-) Halbleiter-Substratfläche trägt nicht nur einer Minimierung des Fotodetektors Rechnung, sondern reduziert auch die Herstellungskosten.

Die erfindungsgemäße Lösung weist den besondere Vorteil auf, daß zur Erzeugung der Abtastsignale die Längserstreckung der Detektorbereiche quer zur Meßrichtung maximal ist, so daß auch unter ungünstigen Bedingungen noch hinreichend Licht eingekoppelt wird.

Vorzugsweise bestehen die Detektorbereiche aus schmalen, rechteck- oder kreisabschnittsförmigen und strahlungsempfindlichen Streifen, deren Längsseiten im wesentlichen senkrecht zur Messrichtung benachbart zueinander angeordnet sind, und die Leiterbahnen sind im wesentlichen senkrecht zu den Längsseiten der Detektorbereiche geführt.

Eine vorteilhafte Ausgestaltung der erfindungsgemäßen Lösung ist dadurch gekennzeichnet, daß der optoelektronische Fotodetektor auf einem halbleitenden Grundkörper des einen Leitfähigkeitstyps angeordnete, die Detektorbereiche bildende dünne, streifenförmige Schichten des anderen Leitfähigkeitstyps, eine die Vorderseite des Fotodetektors bildende Antireflexionsschicht und eine dazwischen angeordnete Isolationsschicht aufweist und dass an den Verbindungen der Leiterbahnen mit zugeordneten Detektorbereichen Öffnungen in der Antireflexionsschicht zur Herstellung von Kontaktpunkten zwischen den Leiterbahnen und den betreffenden Detektorbereichen vorgesehen sind. Alternativ hierzu kann an den Verbindungen der Leiterbahnen mit zugeordnetenDetektorbereichen die Antireflexionsschicht mit den dünnen, streifenförmigen Schichten des anderen Leitfähigkeitstypsverbunden werden, um Kontaktpunkte zum Auskoppeln der in dem betreffenden Detektorbereich gespeicherten Ladung herzustellen.

Eine Weiterbildung der erfindungsgemäßen Lösung ist dadurch gekennzeichnet, dass die Detektorbereiche periodisch und äquidistant zueinander angeordnet sind, wobei mehrere benachbarte Detektorbereiche eine Gruppe bilden, die zueinander phasenversetzte Abtastsignale liefert, und dass jeweils eine Leiterbahn mit den Detektorbereichen der verschiedenen Gruppen verbunden ist, die phasengleicheAbtastsignale abgeben.

Über die gruppenweise zusammengefassten Detektorbereiche ist eine sogenannte "Einfeldabtastung" des Massstabes gewährleistet, bei der sämtliche Signalanteile zur Erzeugung der Abtastsignale stets nur aus einer Teilungsperiode des abgetasteten Massstabes stammen. Eine derartige Anordnung ist insbesondere hinsichtlich der Unempfindlichkeit gegenüber Verschmutzungen des Massstabes vorteilhaft, da die phasenverschobenen Signalanteile, die zur Erzeugung der Abtastsignale beitragen, allesamt gleich beeinflusst werden.

Vorzugsweise bilden jeweils vier aktive Detektorbereiche eine Gruppe, die vier jeweils um 90° phasenversetzte Abtastsignale liefert, wobei mindestens zwei Gruppen aktiver Detektorbereiche in Messrichtung nebeneinander angeordnet und vier parallele Leiterbahnen mit den Detektorbereichender Gruppen verbunden sind, die phasengleiche Abtastsignaleabgeben.

Des weiteren können vorteilhaft mehrere Gruppen aktiver Detektorbereiche in Messrichtung hintereinander und nebeneinander angeordnet werden, wobei eine dem Phasenversatz entsprechende Anzahl Leiterbahnen mit den Detektorbereichen der in Messrichtung hintereinander angeordneten Gruppenverbunden ist, die phasengleiche Abtastsignale liefern. Die phasengleiche Abtastsignale erfassenden Leiterbahnen der in Messrichtung parallel zueinander angeordneten Gruppen sind dabei miteinander verbunden.

Die Verbindung der phasengleichen Abtastsignale erfassendenLeiterbahnen der in Messrichtung parallel zueinander angeordneten Gruppen kann insbesondere auf der Rückseite des strukturierten Fotodetektors angeordnet werden.

Für den Betrieb einer derartigen Abtasteinheit weist der strukturierte Fotodetektor in Messrichtung vorzugsweise mehrere hintereinander angeordnete Gruppen mit jeweils mehreren Detektorbereichen auf, wobei der eine Teil der Gruppen Referenzimpuls-Detektorbereiche zur Erzeugung von Referenzimpuls-Signalen und der andere Teil der Gruppen Inkrementalsignal-Detektorbereiche zur Erzeugung von Inkrementalsignalen enthält. Die Referenzimpuls-Detektorbereichesind mit Referenzimpuls-Leiterbahnen und die Inkrementalsignal-Detektorbereiche, die phasengleiche Ausgangssignaleliefern, sind mit jeweils einer Inkrementalsignal-Leiterbahn verbunden.

Eine vorteilhafte Weiterbildung der erfindungsgemäßen Lösung ist dadurch gekennzeichnet, dass zumindest die Inkrementalsignal-Leiterbahnen über die strahlungsempfindlichen Oberflächen der Inkrementalsignal-Detektorbereichegeführt und jeweils mit phasengleiche Ausgangssignale liefernden Inkrementalsignal-Detektorbereichen verbunden sind.

Weiterhin können zwei Gruppen Inkrementalsignal-Detektorbereiche mit jeweils zwei in Messrichtung hintereinander und nebeneinander angeordneten Gruppen von phasengleiche Ausgangssignale liefernden Detektorbereichen und eine zwischen den beiden Gruppen von Inkrementalsignal-Detektorbereicheneine Gruppe von Referenzimpuls-Detektorbereichen vorgesehen werden, während die Inkrementalsignal-Leiterbahnen jeweils zu den Stirnseiten des strukturierten Fotodetektors geführt sind. Dabei können die Referenzimpuls-Leiterbahnen zwischen den in Messrichtung nebeneinander angeordneten Gruppen von Inkrementalsignal-Detektorbereichen angeordnet werden.

Zur Ereugung der Referenzimpulssignale können die die Taktsignale der Referenzimpuls-Detektorbereiche erfassenden Referenzimpuls-Leiterbahnen zu der einen Stirnseite zwischen den in Messrichtung nebeneinander angeordneten Gruppen von Imkrementalsignal-Detektorbereichen dieser Seite und die die Gegentaktsignale der Referenzimpuls-Detektorbereiche erfassenden Referenzimpuls-Leiterbahnen zu der anderen Stirnseite zwischen den in Messrichtung nebeneinander angeordneten Gruppen von Inkrementalsignal-Detektorbereichen dieser Seite geführt werden.

Alternativ können die die Taktsignale und die die Gegentaktsignale der Referenzimpuls-Detektorbereiche erfassenden Referenzimpuls-Leiterbahnen abschnittsweise übereinanderangeordnet zwischen den in Messrichtung nebeneinanderangeordneten Gruppen von Inkrementalsignal-Detektorbereichen der einen Seite geführt werden.

Da die Leiterbahnen mit einer Isolationsschicht zumindest auf der den Detektorbereichen zugewandten Seite versehen sind, können die Referenzimpuls-Leiterbahnen zumindest teilweise über die einander gegenüberliegenden Seitenränder der in Messrichtung nebeneinander angeordneten Gruppen der Inkrementalsignal-Detektorbereiche geführt werden.

Schließlich können die in Messrichtung jeweils hintereinanderliegenden Gruppen von Inkrementalsignal-Detektorbereichen mit jeweils einer Inkrementalsignal-Leiterbahn für phasengleiche Ausgangssignale verbunden und die Inkrementalsignal-Leiterbahnen über die Referenzimpuls-Detektorbereichegeführt werden.

Anhand von in der Zeichnung dargestellten Ausführungsbeispielen soll der der Erfindung zugrunde liegende Gedanke näher erläutert werden. Es zeigen:
- Fig. 1 bis 3 -: eine optische Positionsmeßeinrichtung mit Abtasteinheit und Maßstab sowie eine vergrößerte Draufsicht auf eine Platine und eine Abtastplatte der Abtasteinheit;
- Fig. 4 -: eine schematische Darstellung mehrerer hintereinander und nebeneinander angeordneter Gruppen von Detektorbereichen zur Erzeugung von Inkrementalsignalen mit Leiterbahnen, die Detektorbereiche mit phasengleichen Abtastsignalen kontaktieren;
- Fig. 5 -: eine schematische Darstellung von neben- und hintereinander angeordneten Gruppen von Inkrementalsignal- und Referenzimpuls-Detektorbereichen sowie Leiterbahnen, die phasen- und taktgleiche Abtastsignale liefernde Detektorbereiche zusammenfassen und
- Fig. 6 -: eine schematisch-perspektivische Darstellung eines Fotodetektors mit einer phasengleiche Abtastsignale abgebende Detektor bereiche zusammenfassende und über die Detektorbereiche gelegten Leiterbahn.

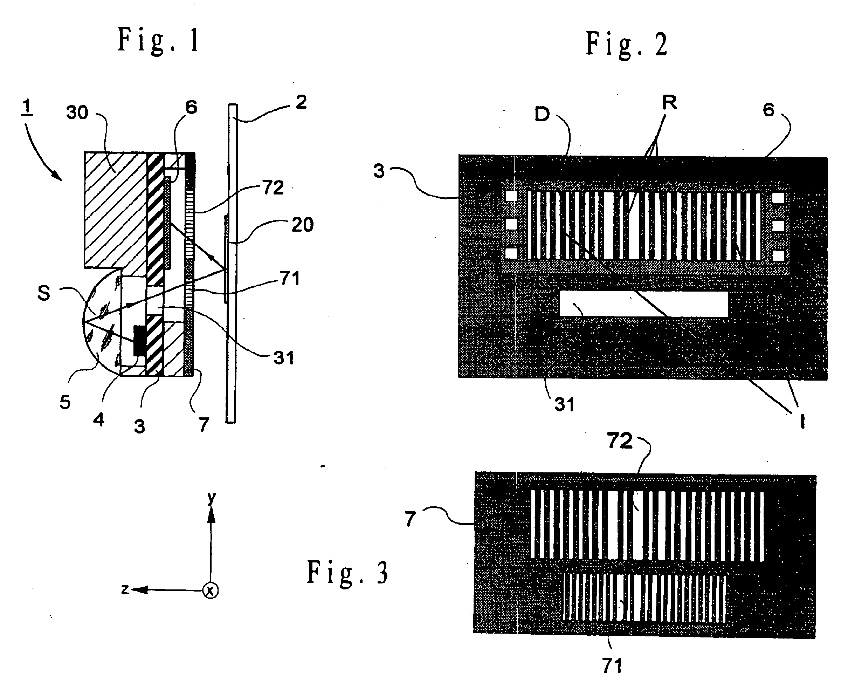

Figur 1 zeigt einen Querschnitt durch eine optische Positionsmesseinrichtung, die eine Abtasteinheit 1 und einen relativ zur Abtasteinheit 1 in Messrichtung x beweglichen Maßstab 2 enthält. Die Abtasteinheit 1 umfasst einen sendeseitigen Teil, der eine Lichtquelle 4, die auf einer in Draufsicht in Figur 2 dargestellten Platine 3, vorzugsweise in Form einer auf der Oberfläche der Platine 3 befestigten lichtemittierenden Diode ausgebildet ist, und eine der Lichtquelle 4 zugeordnete Kollimatoroptik 5 in Form einer Zylinderlinse, die mit ihrer ebenen Fläche der Lichtquelle 4 zugewandt auf einem mit der Platine 3 verbundenen Aufbau 30 befestigt ist.

Im empfangsseitigen Teil der Abtasteinheit 1 ist auf der Platine 3 ein Fotodetektor oder Fotosensor 6 mit verschiedenen aktiven, strahlungsempfindlichen Detektorbereichen D(Figur 2) vorgesehen, zwischen denen jeweils inaktive, strahlungsunempfindliche Bereiche angeordnet sind. In geringem Abstand zur Platine 3 ist eine in Figur 3 in Draufsicht dargestellte Abtastplatte 7 angeordnet, die in Messrichtung x nebeneinander angeordnet eine Sendestruktur 71 und eine Abtaststruktur 72 enthält.

Beabstandet zur Abtasteinheit 1 ist der Maßstab 2 angeordnet, der eine sich in Messrichtung x erstreckende Messteilung 20 enthält, deren optische Abtastung bei der Relativbewegung zwischen Abtasteinheit 1 und Maßstab 2 Abtastsignale liefert. Der in Figur 1 schematisch dargestellte Strahlengang S geht von der Lichtquelle 4 aus und wird mittels der Zylinderlinse 5 durch eine in der Platine 3 vorgesehene, sich in Messrichtung x erstreckende Öffnung 31 zur Abtastplatte 7 und der darauf angeordneten Sendestruktur 71 reflektiert und gelangt durch die Sendestruktur 71 zu der auf dem Maßstab 2 angeordneten Meßteilung 20, von der der Messstrahl S durch die Abtaststruktur 72 zu dem vorzugsweise auf einem Halbleitersubstrat angeordneten Fotodetektor 6mit den darauf vorgesehenen strahlungsempfindlichen Detektorbereichen D reflektiert wird.

Die in Figur 1 dargestellte optische Positionsmesseinrichtung arbeitet im Auflicht, so dass die auf dem Maßstab 2 vorgesehene Messteilung reflektierende und nichtreflektierende Teilbereiche aufweist, die den Strahlengang S reflektieren bzw. nicht reflektieren. Bei einer im Durchlicht arbeitenden optischen Positionsmesseinrichtung befindet sich der Maßstab 2 zwischen dem sendeseitigen Teil der Abtasteinheit 1 und deren empfangsseitigem Teil, so dass der von der Lichtquelle 4 ausgehende Strahlengang über die Zylinderlinse 5 und die Sendestruktur 71 der Abtastplatte zur Messteilung 20 des Maßstabes 2 und durch die Messteilung 20 hindurch über die Sendestruktur 71 zum Fotodetektor 6 der Abtasteinheit 1 gelangt. In diesem Falle sind die auf dem Maßstab 2 vorgesehenen Abtastfelder der Messteilung 20 für die verwendete Lichtwellenlänge durchlässig und nicht-durchlässig ausgebildet.

Um bei einer oder mehreren definierten Relativpositionen der zueinander beweglichen Teile der optischen Positionsmeßeinrichtung einen exakten Absolutbezug der Positionsmessung herzustellen, werden neben den Inkrementalsignalen bezüglich des Relativversatzes auch sogenannte Referenzimpulssignale benötigt, zu deren Erzeugung auf Seiten des Maßstabes der jeweiligen Positionsmeßeinrichtung an einer oder mehreren Positionen Referenzmarkierungsfelder angeordnet sind. Die Abtasteinheit einer derartigen Positionsmeßeinrichtung bietet damit die Möglichkeit, bei der zu detektierenden Relativposition von Maßstab und Abtasteinheit ein entsprechendes Referenzimpulssignal zu erzeugen, das in der nachgeordneten Auswerteeinrichtung geeignet verarbeitet wird.

Zur Erfassung der Relativ- und Absolutposition von Abtasteinheit und Maßstab, die beispielsweise in Werkzeugmaschinen zur Erfassung der relativen und absoluten Position von Werkstück und Werkzeug eingesetzt werden, sind daher entsprechende Referenzmarkierungsfelder auf dem Maßstab und Referenzimpuls-Detektorbereiche R sowie Inkrementalsignal-Detektorbereiche I als Detektorbereiche D auf dem Substrat 3 des Fotodetektors 6 vorgesehen.

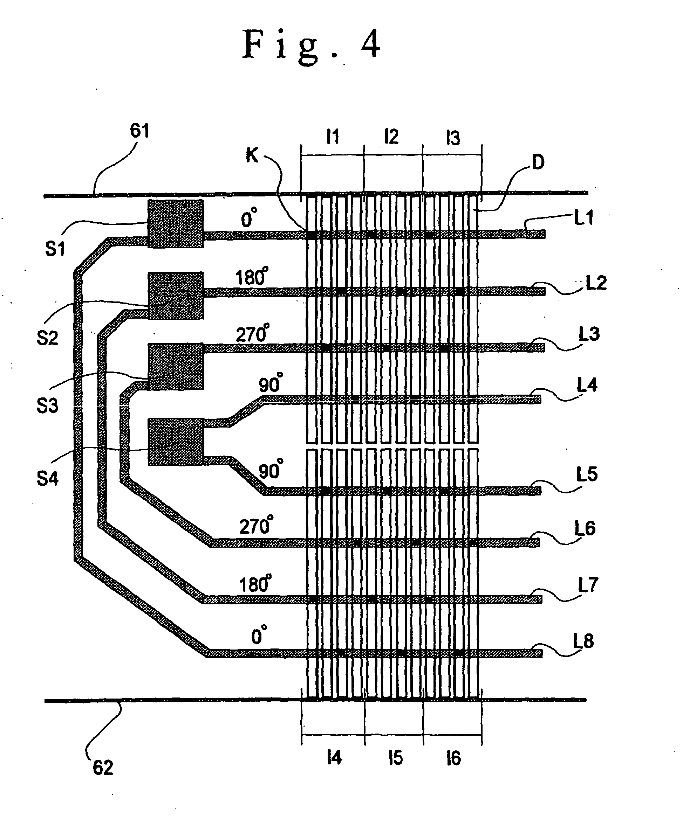

Weitere Einzelheiten zur Aufgabe, Funktion und Gestaltung der Inkrementalteilungsspur und der Referenzmarkierungsfelder auf dem Maßstab sowie der Inkrementalsignal-Detektorbereiche und Referenzimpuls-Detektorbereiche des Fotodetektors zur Erzeugung von Inkremental-und Referenzimpulssignalen sind der vorstehend genannten WO 99/08074 zu entnehmen. Zur Detektion der vom Maßstab 2 kommenden Strahlenbündel ist in den Ausführungsbeispielen der Figuren 4 bis 6 eine strukturierte Detektoranordnung vorgesehen, die aus mehreren aktiven, d.h. strahlungsempfindlichen Detektorbereichen besteht, die jeweils eine schmale Streifenform aufweisen und in Meßrichtung x periodisch und benachbart zueinander angeordnet sind. Hierzu wird ein geeignetes Halbleitersubstrat derart strukturiert, daß auf dem Substrat eine Reihe strahlungsempfindlicher Detektorbereiche resultiert. Die verschiedenen aktiven Detektorbereiche liefern im Fall der Relativbewegung von Maßstab und Abtasteinheit jeweils Signalanteile, die zur Erzeugung phasenversetzter Inkrementalsignale herangezogen werden.

Die in Figur 4 schematisch dargestellte Draufsicht auf einen Fotodetektor zeigt mehrere Gruppen hintereinander und nebeneinander angeordneter Detektorbereiche I1 bis I6 zur Erfassung von Abtastsignalen, die als Inkrementalsignale einer Auswerteeinrichtung zugeführt werden. Vier Inkrementalsignal-Detektorbereiche bilden dabei jeweils eine Gruppe I1 bis I6, wobei jeweils ein Inkrementalsignal-Detektorbe reich ein Teil-Inkrementalsignal mit der Phasenlage 0°, ein Inkrementalsignal-Detektorbereich ein Teil-Inkrementalsignal mit der Phasenlage 180°, ein Inkrementalsignal-Detektorbereich ein Teil-Inkrementalsignal mit der Phasenlage 90° und ein Inkrementalsignal-Detektorbereich ein Teil-Inkrementalsignal mit der Phasenlage 270° liefert.

Selbstverständlich kann auch eine andere Relativanordnungder verschiedenen Inkrementalsignal-Detektorbereiche gewählt werden, so daß diese dann Teil-Inkrementalsignale mit anderen relativen Phasenlagen als in dem in Figur 4 dargestellten Beispiel liefern. Beispielsweise wäre eine Anordnung der Inkrementalsignal-Detektorbereiche möglich, die Signale mit der Phasenlage 0°, 120°, 240°... liefern. Referenzimpulsignal-Detektorbereiche weist diese Anordnung nicht auf.

Die im Beispiel von Figur 4 gezeigte Anordnung der aktiven Detektorbereiche hat zur Folge, daß die innerhalb einer Teilungsperiode liegenden, benachbarten aktiven Detektorbereiche einer Vierergruppe I1 bis I6 bei der optischen Abtastung der Inkrementalteilung vier jeweils um 90° phasenversetzte Abtastsignale liefern. Über die gezeigte Anordnung der Detektorbereiche ist somit eine sogenannte "Einfeldabtastung" des Maßstabes gewährleistet, bei der sämtliche Signalanteile zur Erzeugung der Inkrementalsignale stets nur aus einer Teilungsperiode des abgetasteten Maßstabes stammen. Eine derartige Abtastung ist insbesondere hinsichtlich der Unempfindlichkeit gegenüber großflächigen Verschmutzungen des Maßstabes vorteilhaft, da die phasenverschobenen Signalanteile, die zur Erzeugung der Abtastsignale beitragen, allesamt gleich beeinflußt werden.

In Figur 4 sind schematisch die Seitenränder 6a, 6b der aktiven Fläche des Fotodetektors 6 gemäß Figur 1 dargestellt, die die Seitenränder des Halbleitersubstrats bilden, auf dem die strahlungsempfindlichen Detektorbereiche strukturiert ausgebildet sind. Üblicherweise wird die Länge der aktiven Detektorbereiche senkrecht zur Meßrichtung x dadurch begrenzt, daß die mit den Detektorbereichen verbundenen Leiterbahnen zwischen den Stirnseiten der Detektorbereiche und den Seitenrändern 6a, 6b geführt werden bzw. von den Stirnseiten der Detektorbereiche über die Seitenkanten zur Platine bzw. zur Rückseite des Halbleitersubstrats geführt werden müssen.

Demgegenüber werden in der erfindungsgemäßen Ausführungsform die Leiterbahnen L1 bis L8 quer zur Längserstreckung der Detektorbereiche D über die Oberflächen der Detektorbereiche D geführt. Dabei weisen die Leiterbahnen L1 bis L8 zumindest auf der der Oberseite der Detektorbereiche D zugewandten Seite eine Isolation auf, die nur an vorgegebenen Punkten K zur Kontaktierung mit vorgegebenen Detektorbereichen durchbrochen wird. Auf diese Weise werden phasengleiche Abtastsignale liefernde Detektorbereiche D der einzelnen Gruppen I1 bis I6 zusammengefaßt und über Kontakte S1 bis S4 zur Signalverarbeitung an die Auswerteeinrichtung weitergeleitet.

Das in Figur 4 dargestellte Ausführungsbeispiel zeigt die Zusammenfassung von vier, jeweils um 90° phasenversetzte Abtastsignale, die aus der Verbindung der Leiterbahnen L1 bis L8 mit den jeweiligen Detektorbereichen D der hinter-und nebeneinander angeordneten Gruppen von Detektorbereichen I1 bis I6 resultieren.

Wie der Darstellung gemäß Figur 4 zu entnehmen ist, bewirkt die Führung der Leiterbahnen L1 bis L8 quer über die Längserstreckungen der Detektorbereiche D eine optimale Ausnutzung der zur Verfügung stehenden Fläche des Fotodetektors, indem die Detektorbereiche D bis unmittelbar an die Seitenränder 6a, 6b des Fotodetektors geführt werden können.

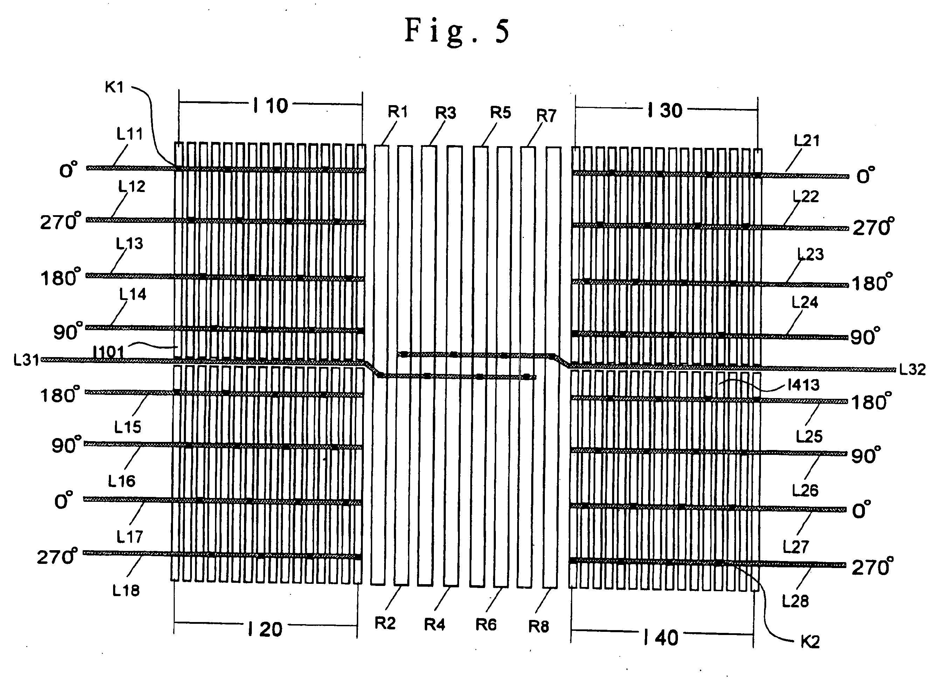

Eine andere Form einer strukturierten Detektoranordnung ist in Figur 5 als Draufsicht auf beispielsweise ein Halbleitersubstrat dargestellt, das die aktiven Detektorbereiche neben den inaktiven Bereichen ausbildet. In dieser Ausführungsform sind sowohl Inkrementalsignale als auch Referenzimpulssignale als Abtastsignale liefernde Detektorbereiche vorgesehen, so daß diese Anordnung geeignet ist, sowohl die relative Stellung zweier relativ zueinander bewegter Systeme als auch eine absolute Position der relativ zueinanderbewegten Systeme zu erfassen.

Die Inkrementalsignale werden in zwei Inkrementalsignal-Detektorbereichen erfaßt, die durch einen Referenzimpulssignal-Detektorbereich voneinander getrennt sind. Die Inkrementalsignal-Detektorbereiche I10, I20; I30 und I40 werden durch gruppenweise zusammengefaßte Teilbereiche gebildet, die in Meßrichtung x hintereinander angeordnet sind. Jeweils phasengleiche Abtastsignale liefernde Detektorbereiche werden mittels quer über die Längserstreckung der Detektorbereiche und damit in Meßrichtung x verlaufender Leiterbahnen L11 bis L28 kontaktiert.

Die Inkrementalsignal-Detektorbereiche I10, I20, I30, I40 liefern jeweils um 90° phasenversetzte Inkrementalsignale und sind dementsprechend über die Leiterbahnen L11 bis L28 durch entsprechende Kontaktpunkte mit den entsprechenden Detektorbereichen zusammengefaßt. So liefern beispielsweise die Leiterbahnen L11, L17, L21 und L27 die Phasenlagen 0°, während die Leiterbahnen L12, L18, L22 und L28 die um 90° phasenversetzten Phasenlagen von 270° über jeweils vier hintereinander angeordnete Detektorgruppen eines Detektorbereichs liefern. Dabei erfaßt beispielsweise die Leiterbahn L11 am Kontaktpunkt K1 den Detektorbereich I101, während die Leiterbahn L28 am Kontaktpunkt K2 den Detektorbereich 1413 erfaßt usw.

Der zwischen den Inkrementalsignal-Detektorbereichen I10, I20, I30, 140 angeordnete Referenzimpulssignal-Detektorbereich weist mehrere in Meßrichtung hintereinander angeordnete identische Referenzimpuls-Detektorbereiche R1 bis R8 auf, die im Unterschied zu den gruppenweise nebeneinander angeordneten Inkrementalsignal-Detektorbereichen durchgehend von der einen zur anderen Seitenkante der Detektoranordnung ausgebildet sind. Zur Erzeugung der Referenzimpulssignale werden die Referenzimpuls-Detektorbereiche R1 bis R8 mit einer Takt- und Gegentaktleitung L31, L32 kontaktiert, wobei jeweils ein Detektorbereich R1 bis R8 übersprungen wird, so daß jeder zweite Detektorbereich R1 bis R8 entweder mit der Taktleitung L31 oder der Gegentaktleitung L32 verbunden ist.

Analog zur Anordnung der Leiterbahnen gemäß Figur 4 sind auch bei dem in Figur 5 dargestellten Ausführungsbeispiel die Leiterbahnen L11 bis L28 quer über die Detektorbereiche der Inkrementalsignal-Detektorbereiche I10, I20, I30, I40 zu den Stirnseiten der Detektoranordnung geführt. Da die Leiterbahnen L11 bis L28 eine insgesamt geringe strahlungsempfindliche Fläche bei der Querung der Detektorbereichebelegen, kann abweichend von der in Fig. 5 dargestellten Konfiguration auch jeweils eine einzelne Leiterbahn über sämtliche (Inkrementalsignal- und Referenzimpuls-) Detektorbereiche geführt werden, um die phasenversetzten Abtastsignale von 0°, 270°, 180° und 90° der in Meßrichtung hintereinander angeordneten Gruppen durch Kontaktgabe mit den entsprechenden Inkrementalsignal-Detektorbereichen zu erfassen. Dies bedingt zwar eine Führung der Leiterbahnen über die Referenzimpuls-Detektorbereiche R1 bis R8 hinüber, würde aber aufgrund der großflächigen Referenzimpuls-Detektorbereiche eine nur geringfügige Beeinträchtigung der Referenzimpuls-Detektorbereiche bedeuten.

Die Takt- und Gegentaktleitung L31, L32 für die Referenzimpuls-Detektorbereiche R1 bis R8 ist in dem in Figur 5 dargestellten Ausführungsbeispiel zwischen die in Meßrichtung x nebeneinander liegenden Inkrementalsignal-Detektorbereiche I10, I20 bzw. I30, I40 hindurchgeführt. Diese Konfiguration nutzt den ohnehin für die Trennung der nebeneinander angeordneten Inkrementalsignal-Detektorbereiche I10, I20 bzw. I30, I40 erforderlichen Spalt aus, so daß keine aktive, d.h. strahlungsempfindliche Fläche beansprucht wird. Durch die Anordnung der Takt- und Gegentaktleitung L31, L32 zwischen den nebeneinander angeordneten Inkrementalsignal-Detektorbereichen I10, I20 sowie I30, I40 ist es möglich, die Stirnseiten sowohl der Inkrementalsignal-Detektorbereiche I10, I20, I30, I40 als auch der Referenzimpuls-Detektorbereiche R1 bis R8 bis unmittelbar an die Seitenkanten der Detektoranordnung zu führen und somit eine maximale aktive, d.h. strahlungsempfindliche Fläche für die Detektorbereiche vorzusehen.

Je nach Konfiguration und Baugröße des Fotodetektors sind aber auch abweichend von den Darstellungen in den Figuren 4 und 5 unterschiedliche Führungen der Leiterbahnen möglich. So kann beispielsweise die Takt- und Gegentaktleitung L31, L32 in der Anordnung gemäß Figur 5 auch an einer Seitenkante der Detektoranordnung entlang geführt werden. Dies schränkt allerdings die Möglichkeit ein, die Stirnseiten sowohl der Inkrementalsignal-Detektorbereiche als auch der Referenzimpuls-Detektorbereiche bis unmittelbar an die Seitenkanten der Detektoranordnung zu führen.

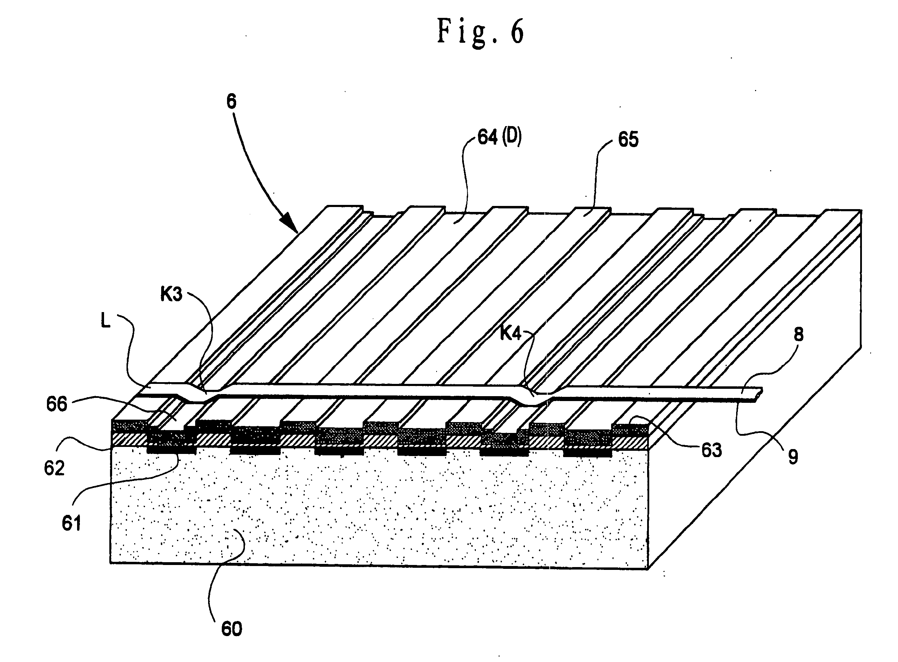

Figur 6 zeigt eine schematisch-perspektivische Ansicht eines optoelektronischen Fotodetektors bzw. Fotosensors mit einer über die Oberfläche des Fotodetektors 6 geführten Leiterbahn L, die an zwei Kontaktierungsstellen K3, K4 mit aktiven, d.h. strahlungsempfindlichen Detektorbereichen des Fotodetektors 6 verbunden ist.

Der halbleitende Grundkörper des optoelektronischen Fotodetektors 6 besteht beispielsweise aus Silizium und umfaßt eine breite n-leitende Schicht 60 (300 µm bis 400 µm dick), an deren Oberfläche sich mehrere äquidistant verteilt angeordnete, wesentlich dünnere p-leitende Schichten 61 (ca. 0,55 µm dick) erstrecken. Zwischen der n-leitenden Schicht 60 und den p-leitenden Schichten 61 bilden sich Raumladungszone (Verarmungszonen) aus, die als Sperrschichten wirken.

Die Vorderseite des optoelektronischen Fotodetektors 6 ist mit einer metallischen Antireflexionsschicht 63 versehenund wird durch eine isolierende Schicht 62 strukturiert, die z. B. aus Siliziumdioxid als Isolator bestehen können. Zwischen den isolierenden oder inaktiven Bereichen 65 erstrecken sich so die aktiven, strahlungsempfindlichenDetektorbereiche 64 bzw. D.

Auf die aktiven, strahlungsempfindlichen Detektorbereiche64 bzw. D auftreffende elektromagnetische Strahlung gelangt durch die p-leitenden Schichten 61 in die Raumladungszone und wird dort zu einem großen Teil absorbiert. Dabei entstehen in der Raumladungszone Elektron-Lochpaare. Das Raumladungsfeld trennt diese Trägerpaare; Elektronen fließen zur n-, Löcher zur p-Seite. Um diesen Fotostrom, der ein Maß für die einfallende Strahlungsleistung ist, messen zu können, wird der optoelektronische Photodetektor 6 in eine geeignete elektrische Schaltung integriert.

Die senkrecht zur Längserstreckung der aktiven Detektorbereiche 64 und über deren Oberfläche verlegte oder anderweitig aufgetragene Leiterbahn L besteht aus einem elektrisch leitfähigen Teil 8 sowie einer Isolationsschicht 9, die zumindest zwischen dem elektrisch leitfähigen Teil 8 und der Oberfläche des optoelektronischen Fotodetektors 6 vorgesehen ist. Die Isolationsschicht 9 bewirkt, daß nur an den gewünschten Stellen die Leiterbahn L die entsprechenden Detektorbereiche D des Fotodetektors 6 kontaktiert, um beispielsweise phasengleiche Abtastsignale zu erfassen und an eine Auswerteinrichtung weiterzuleiten.

An den Kontaktierungspunkten K3, K4, an denen die Leiterbahn L mit den entsprechenden Detektorbereichen 64 bzw. D des Fotodetektors 6 verbunden werden soll, ist eine Öffnung in der Antireflexionsschicht 63 vorgesehen bzw. wie in Figur 6 dargestellt, die Antireflexionsschicht 63 soweit an den Stellen 66 abgesenkt, daß sie unter Überbrückung der Isolationsschicht 62 die p-leitende Schicht 61 kontaktiert und dadurch die entsprechende Ladung zur Erzeugung eines Abtastsignals ausgekoppelt werden kann.

Die Verbindung der Leiterbahn L mit den entsprechenden Detektorbereichen 64 an den Kontaktpunkten K3, K4 kann durch entsprechendes Entfernen der Isolationsschicht 9 oder mittels Durchkontaktierung erfolgen. Beispielsweise kann der elektrisch leitende Teil 8 der Leiterbahn L an den Kontaktpunkten K3, K4 mittels eines Laserstrahls mit der Oberfläche der Antireflexionsschicht 63 bzw. abgesenktenOberfläche 66 des betreffenden Detektorbereichs D leitfähig verbunden werden.

Die Erfindung beschränkt sich in ihrer Ausführung nicht auf die vorstehend angegebenen bevorzugten Ausführungsbeispiele, sondern es ist eine Anzahl von Varianten denkbar, welche von der in der Zeichnung und Beschreibung dargestellten Lösung auch bei grundsätzlich andersgearteten Ausführungen Gebrauch macht.

## Patentansprüche

1. Abtasteinheit für eine optische Positionsmesseinrichtung mit einem strukturierten optoelektronischen Fotodetektor, der mehrere benachbart zueinander auf einem gemeinsamen Halbleitersubstrat angeordnete strahlungsempfindliche Detektorbereiche umfasst, wobei der strukturierte Fotodetektor in Messrichtung (x) mehrere hintereinander angeordnete Gruppen mit jeweils mehreren Detektorbereichen (I10, I20, I30, I40, R1 - R8) aufweist, wobei der eine Teil der Gruppen Referenzimpuls-Detektorbereiche (R1 - R8) zur Erzeugung von Referenzimpuls-Signalen und der andere Teil der Gruppen Inkrementalsignal-Detektorbereiche (110, I20, I30, I40) zur Erzeugung von Inkrementalsignalen aufweist und die Detektorbereiche (I10, I20, I30, I40, R1 - R8) über Leiterbahnen (L11 - L28, L31, L32) mit einer Auswerteinrichtung verbunden sind, wobei die Referenzimpuls-Detektorbereiche (R1 - R8) mit Referenzimpuls-Leiterbahnen (L31, L32) und die Inkrementalsignal-Detektorbereiche (I10, I20, I30, I40), die phasengleiche Ausgangssignale liefern, mit jeweils einer Inkrementalsignal-Leiterbahn (L11 - L28) verbunden sind,
**dadurch gekennzeichnet, dass**
zumindest ein Teil der Leiterbahnen (L11 - L28, L31, L32) über die Oberfläche der Detektorbereiche (I10, I20, I30, I40, R1 - R8) geführt wird, und
dass die Leiterbahnen (L11 - L28, L31, L32) mit einer Isolationsschicht (9) zumindest auf der den Detektorbereichen zugewandten Seite versehen sind, wobei die Leiterbahnen (L11 - L28, L31, L32) die Detektorbereiche (I10, I20, 130, I40, R1 - R8) nur an gewünschten Stellen kontaktieren.

2. Abtasteinheit nach Anspruch 1, **dadurch gekennzeichnet, dass** die Detektorbereiche (I10, I20, I30, I40, R1 - R8) aus schmalen, rechteck- oder kreisabschnittsförmigen und strahlungsempfindlichen Streifen bestehen, deren Längsseiten im wesentlichen senkrecht zur Messrichtung (x) benachbart zueinander angeordnet sind, und dass die Leiterbahnen (L11 - L28, L31, L32) im wesentlichen senkrecht zu den Längsseiten der Detektorbereiche (I10, I20, I30, I40; R1 - R8) geführt sind.

3. Abtasteinheit nach Anspruch 1 oder 2, **dadurch gekennzeichnet, dass** der optoelektronische Fotodetektor (6) auf einem halbleitenden Grundkörper (60) des einen Leitfähigkeitstyps angeordnete, die Detektorbereiche (I10, I20, I30, I40, R1 - R8) bildende dünne, streifenförmige Schichten des anderen Leitfähigkeitstyps (61), eine die Vorderseite des Fotodetektors (6) bildende Antireflexionsschicht (63) und eine dazwischen angeordnete Isolationsschicht (62) aufweist und dass an den Verbindungen der Leiterbahnen (L11 - L28, L31, L32) mit zugeordneten Detektorbereichen (I10, I20, I30, I40, R1 - R8) Öffnungen in der Antireflexionsschicht (63) vorgesehen sind.

4. Abtasteinheit nach Anspruch 1 oder 2, **dadurch gekennzeichnet, dass** der optoelektronische Fotodetektor (6) auf einem halbleitenden Grundkörper (60) des einen Leitfähigkeitstyps angeordnete, die Detektorbereiche (I10, I20, I30, I40, R1 - R8) bildende dünne, streifenförmige Schichten des anderen Leitfähigkeitstyps (61), eine die Vorderseite des Fotodetektors (6) bildende Antireflexionsschicht (63) und eine dazwischen angeordnete Isolationsschicht (62) aufweist und dass an den Verbindungen der Leiterbahnen (L11 - L28, L31, L32) mit zugeordneten Detektorbereichen (I10, 120, I30, I40, R1 - R8) die Antireflexionsschicht (63) mit den dünnen, streifenförmigen Schichten (61) des anderen Leitfähigkeitstyps verbunden ist.

5. Abtasteinheit nach mindestens einem der vorangehenden Ansprüche, **dadurch gekennzeichnet, dass** die Detektorbereiche (I10, 120, I30, I40, R1 - R8) periodisch zueinander angeordnet sind, wobei mehrere benachbarte Detektorbereiche eine Gruppe bilden, die zueinander phasenversetzte Abtastsignale liefert, und dass jeweils eine Leiterbahn (L11 - L28, L31, L32) mit den Detektorbereichen (I10, I20, I30, I40, R1 - R8) der verschiedenen Gruppen verbunden ist, die phasengleiche Abtastsignale abgeben.

6. Abtasteinheit nach Anspruch 5, **dadurch gekennzeichnet, dass** vier aktive Detektorbereiche eine Gruppe bilden, die vier jeweils um 90° phasenversetzte Abtastsignale liefert, dass mindestens zwei Gruppen aktiver Detektorbereiche (I10, I20, I30, I40) in Messrichtung (x) nebeneinanderangeordnet sind und dass vier parallele Leiterbahnen (L11 - L28) mit den Detektorbereichen (I10, I20, I30, I40) der Gruppen verbunden sind, die phasengleiche Abtastsignale abgeben.

7. Abtasteinheit nach Anspruch 5 oder 6, **dadurch gekennzeichnet, dass** mehrere Gruppen aktiver Detektorbereiche (I10, I20, I30, I40) in Messrichtung (x) hintereinander und nebeneinander angeordnet sind, dass eine dem Phasenversatz entsprechende Anzahl Leiterbahnen (L11 - L28) mit den Detektorbereichen (I10, I20, I30, I40) der in Messrichtung (x) hintereinander angeordneten Gruppen verbunden ist, die phasengleiche Abtastsignale liefern, und dass die phasengleiche Abtastsignale erfassenden Leiterbahnen (L11 - L28) der in Messrichtung (x) parallel zueinander angeordneten Gruppen miteinander verbunden sind.

8. Abtasteinheit nach Anspruch 7, **dadurch gekennzeichnet, dass** die Verbindung der phasengleiche Abtastsignale erfassenden Leiterbahnen (L11 - L28) der in Messrichtung (x) parallel zueinander angeordneten Gruppen auf der Rückseite des strukturierten Fotodetektors (6) angeordnet ist.

9. Abtasteinheit nach Anspruch 1, **dadurch gekennzeichnet, dass** zumindest die Inkrementalsignal-Leiterbahnen (L11 - L28) über die strahlungsempfindlichen Oberflächen der Inkrementalsignal-Detektorbereiche (I10, I20, I30, I40) geführt und jeweils mit phasengleiche Ausgangssignale liefernden Inkrementalsignal-Detektorbereichen (I10, I20, I30, I40) verbunden sind.

10. Abtasteinheit nach Anspruch 1, **dadurch gekennzeichnet, dass** zwei Gruppen Inkrementalsignal-Detektorbereiche (I10, I20, I30, I40) mit jeweils zwei in Messrichtung (x) hintereinander und nebeneinanderangeordneten Gruppen von phasengleiche Ausgangssignale liefernden Detektorbereichen (I10, I20, I30, I40) und eine zwischen den beiden Gruppen von Inkrementalsignal-Detektorbereichen (I10, I20, I30, I40) eine Gruppe von Referenzimpuls-Detektorbereichen (R1 - R8) vorgesehen ist, und dass die Inkrementalsignal-Leiterbahnen (L11 - L28) jeweils zu den Stirnseiten des strukturierten Fotodetektors (6) geführt sind.

11. Abtasteinheit nach Anspruch 10, **dadurch gekennzeichnet, dass** die Referenzimpuls-Leiterbahnen (R1 - R8) zwischen die in Messrichtung nebeneinander angeordneten Gruppen von Inkrementalsignal-Detektorbereichen (I10, I20, I30, I40) geführt sind.

12. Abtasteinheit nach Anspruch 11, **dadurch gekennzeichnet, dass** die die Taktsignale der Referenzimpuls-Detektorbereiche (R1 - R8) erfassende Referenzimpuls-Leiterbahn (L31) zu der einen Stirnseite zwischen den in Messrichtung (x) nebeneinander angeordneten Gruppen von Imkrementalsignal-Detektorbereichen (I10, I20) dieser Seite und die die Gegentaktsignale der Referenzimpuls-Detektorbereiche (R1 - R8) erfassende Referenzimpuls-Leiterbahn (L32) zu der anderen Stirnseite zwischen den in Messrichtung (x) nebeneinander angeordneten Gruppen von Inkrementalsignal-Detektorbereichen(I30, I40) dieser Seite geführt sind.

13. Abtasteinheit nach Anspruch 11, **dadurch gekennzeichnet, dass** die die Taktsignale und die die Gegentaktsignale der Referenzimpuls-Detektorbereiche (R1 - R8) erfassenden Referenzimpuls-Leiterbahnen (L31, L32) abschnittsweise übereinander angeordnet zwischen den in Messrichtung (x) nebeneinander angeordneten Gruppen von Inkrementalsignal-Detektorbereichen (I10, I20, I30, I40) der einen oder anderen Seite geführt sind.

14. Abtasteinheit nach Anspruch 10, **dadurch gekennzeichnet, dass** die Referenzimpuls-Leiterbahnen (L31, L32) zumindest teilweise über die einander gegenüberliegenden Schmalseiten der in Messrichtung (x) nebeneinander angeordneten Gruppen der Inkrementalsignal-Detektorbereiche (I10, I20, I30, I40) geführt sind.

15. Abtasteinheit nach mindestens einem der vorangehenden Ansprüche 10 bis 12, **dadurch gekennzeichnet, dass** die in Messrichtung (x) jeweils hintereinanderliegenden Gruppen von Inkrementalsignal-Detektorbereichen (I10, I20, I30, I40) mit jeweils einer Inkrementalsignal-Leiterbahn (L11 - L28) für phasengleiche Ausgangssignale verbunden sind und dass die Inkrementalsignal-Leiterbahnen (L11 - L28) über die Referenzimpuls-Detektorbereiche (R1 - R8) geführt sind.

## Claims

1. A scanning unit for an optical position measuring device comprising a structured optoelectronic photodetector, which comprises a plurality of radiation-sensitive detector areas, which are arranged adjacent to one another on a common semiconductor substrate, wherein the structured photodetector encompasses a plurality of groups arranged behind one another in measuring direction (x) in each case comprising a plurality of detector areas (I10, I20, I30, I40, R1-R8), wherein the one part of the groups encompasses reference impulse detector areas (R1-R8) for generating reference impulse signals and the other part of the groups encompasses incremental signal detector areas (I10, I20, I30, I40) for generating incremental signals and the detector areas (I10, I20, I30, I40, R1-R8) are connected to an evaluating device via conductor tracks (L11-L28, L31, L32), wherein the reference impulse detector areas (R1-R8) are connected to reference impulse conductor tracks (L31, L32) and the incremental signal detector areas (I10, I20, I30, I40), which supply in-phase output signals, are in each case connected to an incremental signal conductor track (L11-L28),
**characterized in that**
at least a part of the conductor tracks (L11-L28, L31, L32) is guided across the surface of the detector areas (I10, I20, 130, I40, R1-R8), and
that the conductor tracks (L11-L28, L31, L32) are provided with an insulation layer (9) at least on the side facing the detector areas, wherein the conductor tracks (L11-L28, L31, L32) contact the detector areas (I10, I20, I30, I40, R1-R8) only at the desired locations.

2. The scanning unit according to claim 1, **characterized in that** the detector areas (I10, I20, I30, I40, R1-R8) consist of narrow strips, which are rectangular or which have the shape of a segment of a circle and which are radiation-sensitive, the longitudinal sides of which are arranged adjacent to one another substantially vertically to the measuring direction (x), and **in that** the conductor tracks (L11-L28, L31, L32) are guided substantially vertically to the longitudinal sides of the detector areas (I10, I20, I30, I40; R1-R8).

3. The scanning unit according to claim 1 or 2, **characterized in that** the optoelectronic photodetector (6) encompasses thin, strip-shaped layers of the other conductivity type (61), which are arranged on a semiconducting base body (60) of the one conductivity type and which form the detector areas (I10, I20, I30, I40, R1-R8), an anti-reflective layer (63), which forms the front side of the photodetector (6) and an insulation layer (62) arranged therebetween, and **in that** provision is made at the connections of the conductor tracks (L11-L28, L31, L32) comprising assigned detector areas (I10, I20, I30, I40, R1-R8), for openings in the anti-reflective layer (63).

4. The scanning unit according to claim 1 or 2, **characterized in that** the optoelectronic photodetector (6) encompasses thin, strip-shaped layers of the other conductivity type (61), which are arranged on a semiconducting base body (60) of the one conductivity type and which form the detector areas (I10, I20, I30, I40, R1-R8), an anti-reflective layer (63), which forms the front side of the photodetector (6) and an insulation layer (62) arranged therebetween, and **in that** the anti-reflective layer (63) is connected to the thin, strip-shaped layers (61) of the other conductivity type at the connections of the conductor tracks (L11-L28, L31, L32) comprising assigned detector areas (I10, I20, I30, I40, R1-R8).

5. The scanning unit according to at least one of the preceding claims, **characterized in that** the detector areas (I10, I20, I30, I40, R1-R8) are arranged periodically to one another, wherein a plurality of adjacent detector areas form a group, which supplies scanning signals, which are phase-shifted to one another, and **in that** one conductor track (L11-L28, L31, L32) is in each case connected to the detector areas (I10, I20, I30, I40, R1-R8) of the different groups, which emit in-phase scanning signals.

6. The scanning unit according to claim 5, **characterized in that** four active detector areas form a group, which supplies four scanning signals, which are in each case phase-shifted by 90°, **in that** at least two groups of active detector areas (I10, I20, 130, I40) are arranged next to one another in measuring direction (x) and **in that** four parallel conductor tracks (L11-L28) are connected to the detector areas (I10, I20, I30, I40) of the groups, which emit in-phase scanning signals.

7. The scanning unit according to claim 5 or 6, **characterized in that** a plurality of groups of active detector areas (I10, I20, I30, I40) are arranged behind one another and next to one another in measuring direction (x), **in that** a number of conductor tracks (L11-L28), which corresponds to the phase shift, is connected to the detector areas (I10, I20, I30, I40) of the groups, which are arranged behind one another in measuring direction (x) and which supply in-phase scanning signals, and **in that** the conductor tracks (L11-L28), which detect in-phase scanning signals, of the groups, which are arranged parallel to one another in measuring direction (x), are connected to one another.

8. The scanning unit according to claim 7, **characterized in that** the connection of the conductor tracks (L11-L28), which detect the connection of the in-phase scanning signals, of the groups, which are arranged parallel to one another in measuring direction (x), is arranged on the rear side of the structured photodetector (6).

9. The scanning unit according to claim 1, **characterized in that** at least the incremental signal conductor tracks (L11-L28) are guided via the radiation-sensitive surfaces of the incremental signal detector areas (I10, I20, I30, I40) and are in each case connected to incremental signal detector areas (I10, I20, I30, I40), which supply in-phase output signals.

10. The scanning unit according to claim 1, **characterized in that** provision is made for two groups of incremental signal detector areas (I10, I20, I30, I40) comprising in each case two groups of detector areas (I10, I20, I30, I40), which are arranged in each case behind one another and next to one another in measuring direction (x) and which supply in-phase output signals, and for a group of reference impulse detector areas (R1-R8) between the two groups of incremental signal detector areas (I10, I20, I30, I40), and **in that** the incremental signal conductor tracks (L11-L28) are in each case guided to the front faces of the structured photodetector (6).

11. The scanning unit according to claim 10, **characterized in that** the reference impulse conductor tracks (R1-R8) are guided between the groups of incremental signal detector areas (I10, I20, I30, I40), which are arranged next to one another in measuring direction.

12. The scanning unit according to claim 11, **characterized in that** the reference impulse conductor track (L31), which detects the clock signals of the reference impulse detector areas (R1-R8), is guided to the one front face between the groups of incremental signal detector areas (I10, I20) of this side, which are arranged next to one another in measuring direction (x), and the reference impulse conductor track (L32), which detects the push-pull signals of the reference impulse detector areas (R1-R8), is guided to the other front face between the groups of incremental signal detector areas (I30, I40) of this side, which are arranged next to one another in measuring direction (x).

13. The scanning unit according to claim 11, **characterized in that** the reference impulse conductor tracks (L31, L32), which detect the clock signals and the push-pull signals of the reference impulse detector areas (R1-R8), are guided so as to be arranged on top of one another in sections between the groups of incremental signal detector areas (I10, I20, I30, I40), which are arranged next to one another in measuring direction (x), of the one or the other side.

14. The scanning unit according to claim 10, **characterized in that** the reference impulse conductor tracks (L31, L32) are guided at least partially via the narrow sides, which are located opposite one another, of the groups of the incremental signal detector areas (I10, I20, I30, I40), which are arranged next to one another in measuring direction (x).

15. The scanning unit according to at least one of the preceding claims 10 to 12, **characterized in that** the groups of incremental signal detector areas (I10, I20, I30, I40), which are in each case located behind one another from one another in measuring direction (x), are in each case connected to an incremental signal conductor track (L11-L28) for in-phase output signals, and **in that** the incremental signal conductor tracks (L11-L28) are guided via the reference impulse detector areas (R1-R8).

## Revendications

1. Unité de balayage pour un dispositif de mesure de position optique, avec un photo-détecteur optoélectronique structuré comprenant plusieurs zones de détection sensibles au rayonnement, qui sont agencées les unes à côté des autres, sur un substrat semi-conducteur commun, dans laquelle le photo-détecteur structuré comporte plusieurs groupes de zones de détection (I10, I20, I30, I40, R1 - R8), agencés les uns à la suite des autres dans la direction de mesurage (x), dans laquelle une partie des groupes comporte des zones de détection d'impulsions de référence (R1 - R8), pour la génération de signaux d'impulsions de référence, et l'autre partie des groupes de zones de détection de signaux incrémentaux (I10, I20, I30, I40), pour la génération de signaux incrémentaux, et les zones de détection (I10, I20, I30, I40, R1 - R8) sont reliées à un dispositif d'évaluation par le biais de pistes conductrices (L11 - L28, L31, L32), dans laquelle les zones de détection d'impulsions de référence (R1 - R8) sont reliées aux pistes conductrices d'impulsions de référence (L31, L32), et les zones de détection de signaux incrémentaux (I10, I20, I30, I40) fournissant les signaux de sortie en phase sont reliées chacune à une piste conductrice de signaux incrémentaux (L11 - L28),
**caractérisée en ce que**
au moins une partie des pistes conductrices (L11 - L28, L31, L32) est conduite sur la surface des zones de détection (I10, 120, I30, I40, R1 - R8), et
**en ce que** les pistes conductrices (L11 - L28, L31, L32) sont pourvues d'une couche isolante (9), au moins du côté tourné vers les zones de détection, les pistes conductrices (L11 - L28, L31, L32) n'étant en contact que par endroits avec les zones de détection (I10, I20, I30, I40, R1 - R8).

2. Unité de balayage selon la revendication 1, **caractérisée en ce que** les zones de détection (I10, I20, I30, I40, R1 - R8) sont constituées de bandes étroites, sensibles au rayonnement et présentant une forme rectangulaire ou en segment de cercle, dont les côtés longitudinaux sont agencés de façon adjacente, quasiment verticalement à la direction de mesurage (x), et **en ce que** les pistes conductrices (L11 - L28, L31, L32) sont conduites quasiment verticalement aux côtés longitudinaux des zones de détection (I10, I20, I30, I40, R1 - R8).

3. Unité de balayage selon la revendication 1 ou 2, **caractérisée en ce que** le photo-détecteur optoélectronique (6) comporte, sur un corps de base semi-conducteur (60) d'un type de conductivité, des couches fines en forme de bandes de l'autre type de conductivité (61), qui forment les zones de détection (I10, I20, I30, I40, R1 - R8), une couche anti-réfléchissante (63) formant une face avant du photo-détecteur (6), ainsi qu'une couche isolante (62) intermédiaire, et **en ce que** des ouvertures sont prévues dans la couche anti-réfléchissante (63), aux endroits où les pistes conductrices (L11 - L28, L31, L32) sont connectées aux zones de détection (I10, I20, I30, I40, R1 - R8) correspondantes.

4. Unité de balayage selon la revendication 1 ou 2, **caractérisée en ce que** le photo-détecteur optoélectronique (6) comporte, sur un corps de base semi-conducteur (60) d'un type de conductivité, des couches fines en forme de bandes de l'autre type de conductivité (61), qui forment les zones de détection (I10, I20, I30, I40, R1 - R8), une couche anti-réfléchissante (63) formant une face avant du photo-détecteur (6), ainsi qu'une couche isolante (62) intermédiaire, et **en ce que** la couche anti-réfléchissante (63) est reliée aux couches fines (61) en forme de bandes de l'autre type de conductivité, aux endroits où les pistes conductrices (L11 - L28, L31, L32) sont connectées aux zones de détection (I10, I20, I30, I40, R1 - R8) correspondantes.

5. Unité de balayage selon au moins l'une des revendications précédentes, **caractérisée en ce que** les zones de détection (I10, I20, I30, I40, R1 - R8) sont agencées de façon périodique les unes par rapport aux autres, dans laquelle plusieurs zones de détection adjacentes forment un groupe fournissant des signaux de balayage décalés en phase, et **en ce qu'**une piste conductrice (L11 - L28, L31, L32) est respectivement reliée aux zones de détection (I10, I20, I30, I40, R1 - R8) des différents groupes qui fournissent des signaux de balayage présentant des phases identiques.

6. Unité de balayage selon la revendication 5, **caractérisée en ce que** quatre zones de détection actives forment un groupe fournissant respectivement quatre signaux de balayage décalés en phase de 90°, **en ce qu'**au moins deux groupes de zones de détection (I10, I20, I30, I40) actives sont agencés côte à côte dans la direction de mesurage (x), et **en ce que** quatre pistes conductrices (L11 - L28) parallèles sont reliées aux zones de détection (I10, I20, I30, I40) des groupes qui délivrent des signaux de balayage présentant des phases identiques.

7. Unité de balayage selon la revendication 5 ou 6, **caractérisée en ce que** plusieurs groupes de zones de détection (I10, I20, I30, I40) actives sont agencées les uns à côté des autres et les uns après les autres dans la direction de mesurage (x), **en ce qu'**un nombre de pistes conductrices (L11 - L28) correspondant au décalage de phase sont reliées aux zones de détection (110, I20, I30, I40) des groupes agencés les uns après les autres dans la direction de mesurage (x) qui fournissent des signaux de balayage présentant des phases identiques, et **en ce que** les pistes conductrices (L11 - L28) des groupes agencés parallèlement les uns aux autres dans la direction de mesurage (x), qui détectent des signaux de balayage en phase, sont reliées entre elles.

8. Unité de balayage selon la revendication 7, **caractérisée en ce que** la connexion des pistes conductrices (L11 - L28) des groupes agencés parallèlement les uns aux autres dans la direction de mesurage (x), qui détectent des signaux de balayage en phase, est prévue sur la face arrière du photo-détecteur structuré (6).

9. Unité de balayage selon la revendication 1, **caractérisée en ce qu'**au moins les pistes conductrices de signaux incrémentaux (L11 - L28) sont conduites sur les surfaces sensibles au rayonnement des zones de détection de signaux incrémentaux (I10, I20, I30, I40), et reliées respectivement à des zones de détection de signaux incrémentaux (I10, I20, I30, I40) fournissant des signaux de sortie présentant des phases identiques.

10. Unité de balayage selon la revendication 1, **caractérisée en ce qu'**il est prévu deux groupes de zones de détection de signaux incrémentaux (I10, I20, I30, I40), comportant chacun deux groupes de zones de détection (I10, I20, I30, I40) fournissant des signaux de sortie en phase, agencés côte à côte et l'un après l'autre dans la direction de mesurage (x), et un groupe de zones de détection d'impulsions de référence (R1 -R8) est prévu entre les deux groupes de zones de détection de signaux incrémentaux (I10, I20, I30, I40), et **en ce que** les pistes conductrices de signaux incrémentaux (L11 - L28) sont conduites respectivement vers les côtés avant du photo-détecteur structuré (6).

11. Unité de balayage selon la revendication 10, **caractérisée en ce que** les pistes conductrices d'impulsions de référence (R1 - R8) sont conduites entre les groupes de zones de détection de signaux incrémentaux (I10, I20, I30, I40) agencés côte à côte dans la direction de mesurage.

12. Unité de balayage selon la revendication 11, **caractérisée en ce que** la piste conductrice d'impulsions de référence (L31) détectant les signaux d'horloge des zones de détection d'impulsions de référence (R1 - R8) est conduite vers le côté avant entre les groupes de zones de détection de signaux incrémentaux (I10, I20) agencés côte à côte dans la direction de mesurage (x) de ce côté, et la piste conductrice d'impulsions de référence (L32) détectant les signaux push-pull des zones de détection d'impulsions de référence (R1 - R8) est conduite vers l'autre côté avant entre les groupes de zones de détection de signaux incrémentaux (I30, I40) agencés côte à côte dans la direction de mesurage (x) de ce côté.

13. Unité de balayage selon la revendication 11, **caractérisée en ce que** les pistes conductrices d'impulsions de référence (L31, L32) détectant les signaux d'horloge et les signaux symétriques des zones de détection d'impulsions de référence (R1 - R8) sont conduites de façon partiellement superposée entre les groupes de zones de détection de signaux incrémentaux (I10, I20, I30, I40) agencés côte à côte dans la direction de mesurage (x) de l'un ou de l'autre côté.

14. Unité de balayage selon la revendication 10, **caractérisée en ce que** les pistes conductrices d'impulsions de référence (L31, L32) sont conduites au moins partiellement sur les côtés étroits opposés des groupes de zones de détection de signaux incrémentaux (I10, I20, I30, I40) agencés côte à côte dans la direction de mesurage (x).

15. Unité de balayage selon au moins l'une des revendications 10 à 12, **caractérisée en ce que** les groupes de zones de détection de signaux incrémentaux (I10, I20, I30, I40) agencés les uns après les autres dans la direction de mesurage (x) sont reliés chacun à une pistes conductrices de signaux incrémentaux (L11 - L28) pour des signaux de sortie présentant des phases identiques, et **en ce que** les pistes conductrices de signaux incrémentaux (L11 - L28) sont conduites sur les zones de détection d'impulsions de référence (R1 - R8).
